Europäisches Patentamt

European Patent Office

Office européen des brevets

(11) Veröffentlichungsnummer: **0 311 839**
**A1**

# (12) EUROPÄISCHE PATENTANMELDUNG

(21) Anmeldenummer: 88115945.3

(22) Anmeldetag: 28.09.88

(51) Int. Cl.⁴: **H01L 29/72 , H03K 17/73 , H03K 17/78**

(30) Priorität: 16.10.87 CH 4077/87

(43) Veröffentlichungstag der Anmeldung:
19.04.89 Patentblatt 89/16

(84) Benannte Vertragsstaaten:
AT CH DE FR GB IT LI

(71) Anmelder: BBC Brown Boveri
Aktiengesellschaft

CH-5401 Baden(CH)

(72) Erfinder: Grüning, Horst, Dr.
im Ergel 10
CH-5404 Baden(CH)

(54) Abschaltbares Halbleiterbauelement sowie Schaltungsanordnung mit diesem Bauelement.

(57) Bei einem feldgesteuerten Thyristor (FCTh) werden durch geeignete Auslegung der Gate-Kathoden-Struktur normally-OFF-Eigenschaften realisiert, die zu vereinfachten Schaltungsanordnungen beim Betrieb des Bauelements führen.

Fig.3

EP 0 311 839 A1

ABSCHALTBARES HALBLEITERBAUELEMENT SOWIE SCHALTUNGSANORDNUNG MIT DIESEM BAUELEMENT

TECHNISCHES GEBIET

Die Erfindung bezieht sich auf das Gebiet der Halbleiterbauelemente. Sie betrifft insbesondere ein abschaltbares Halbleiterbauelement in Form eines feldgesteuerten Thyristors (FCTh = Field Controlled Thyristor) mit einer Anode, einer Kathode und einem Gate, umfassend zwischen der Anode und der Kathode
- eine p-leitende Anodenschicht;
- eine darüberliegende, n-leitende Kanalschicht, und
- eine Mehrzahl von auf der Kathodenseite abwechselnd angeordneten, n-leitenden Kathodenbereichen und p-leitenden Gatebereichen; wobei
- die Gatebereiche sich über die Böden der Gräben erstrecken;
und
- in den Grabenwänden Mittel vorgesehen sind, welche Raumladungszonen erzeugen, die innerhalb der Kathodenfinger in die Kanalschicht hineinreichen und in jedem Kathodenfinger einen feldeffektsteuerbaren Langkanal bilden.

Die Erfindung betrifft weiterhin eine erste Schaltungsanordnung mit einer Thyristorkaskade, welche Thyristorkaskade einen ersten FCTh als Hauptthyristor und einen zweiten FCTh als Steuerthyristor umfasst. Sie betrifft aber auch eine zweite Schaltungsanornung mit einem FCTh und einer Ansteuereinrichtung.

STAND DER TECHNIK

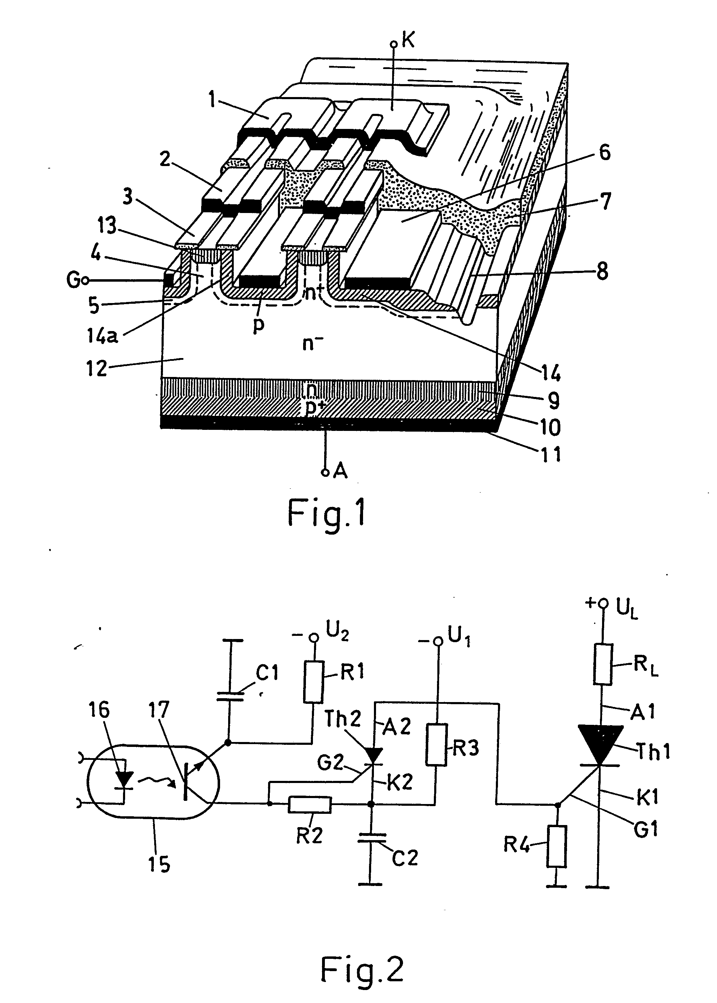

Ein FCTh der oben genannten Art, wie er auch in der Fig. 1 dargestellt ist, wurde bereits von H.Grüning et al. auf dem International Electron Devices Meeting (IEDM) 1986, S. 110 -113, beschrieben.

Charakteristisch für derartige FCThs sind die Kathodenfinger, deren Seitenwende ähnlich wie die Gatebereiche auf den Grabenbeden dotiert sind und eine Steuerung des Bauelements über den ganzen im Kathodenfinger gebildeten Kanal (Langkanal) ermöglichen.

Im eingeschalteten Zustand (ON-Zustand) des Bauelements ist nur eine p-i-n-Struktur wirksam, d.h. eine einfache Diodenstruktur. Es ist daher weder ein Zündstrom nötig, um das Bauelement einzuschalten, noch ein Haltestrom, um das Bauelement im eingeschalteten Zustand zu halten: Wie jede Diode ist dieser FCTh, wenn Gate und Kathode kurzgeschlossen sind, eingeschaltet (normally ON).

Beim Abschalten mittels einer negativen Gatespannung werden zuerst die Kathodenfinger ausgeräumt, indem die im Kanalgebiet vorhandenen Löcher über das Gate abgesaugt und die Elektronen durch Feldeffekt verdrängt werden. Anschliessend kann das Volumen, ähnlich wie beim GTO, Sperrspannung aufnehmen.

Die speziellen Vorteile des FCTh in dieser Form sind:
- kleine Verluste im ON-Zustand wegen der beidseitigen Ladungsträgerinjektion;
- eine weite Safe Operating Area, also ein Betrieb ohne Snubber-Beschaltung;
- die Reduktion der Ansteuerung auf einen kurzen Stromimpuls beim Abschalten; und
- eine vergleichsweise (z.B. gegenüber dem Insulated Gate Bipolar Transistor IGBT) grobe STruktur mit etwa 30 $\mu$m breiten und tiefen Kathodenfingern bzw. Gräben.

Auf der anderen Seite ist jedoch zu berücksichtigen, dass der FCTh in der bekannten Form bei fehlender Ansteuerung im ON-Zustand ist und ausserdem eine Abschaltstromverstärkung kleiner 1 aufweist, wenn man im Betrieb ohne Snubber-Beschaltung auskommen will.

Für die praktische Anwendung des normally-ON-FCTh ist deshalb in der älteren Europäischen Patentanmeldung Nr. 87 106 366.5 (entsprechend der US-Patentanmeldung Serial No. 07/046,319) eine spezielle Ansteuerschaltung in Form einer Thyristor-Kaskade (Fig. 2) vorgeschlagen worden, welche sowohl die oben genannten Vor- als auch Nachteile des Bauelements in optimaler Weise berücksichtigt.

Obgleich diese vorangemeldete Kaskadenschaltung im Bezug auf den normally-ON-FCTh optimiert ist, haftet ihr ein wesentlicher Nachteil an, der direkt mit der normally-ON-Eigenschaft des Bauelements verknüpft ist: Um nämlich den FCTh-Steuerthyristor in der Kaskade im für den Betrieb notwendigen OFF-Zustand zu halten, wird eine zusätzliche negative Spannung (U₂ in Fig. 2) benötigt, wodurch die Schaltungsanordnung insgesamt relativ aufwendig wird.

## DARSTELLUNG DER ERFINDUNG

Aufgabe der vorliegenden Erfindung ist es nun, einen FCTh zu schaffen, welcher die durch die normally-ON-Eigenschaft vorgegebenen Beschränkungen überwindet, sowie entsprechende vereinfachte Schaltungsanordnungen für den Betrieb eines solchen FCTh anzugeben.

Die Aufgabe wird bei einem FCTh der eingangs genannten Art dadurch gelöst, dass in den Kathodenfingern die Raumladungszonen bei einem Kurzschluss zwischen Gate und Kathode soweit in die in den Kathodenfingern befindliche Kanalschicht hineinreichen, dass der Langkanal gesperrt ist.

Die erste Schaltungsanordnung nach der Erfindung ist dadurch gekennzeichnet, dass der zweite FCTh ein abschaltbares Halbleiterbauelement der erfindungsgemessen Art ist.

Die zweite Schaltungsanordnung nach der Erfindung ist dadurch gekennzeichnet, dass
- der FCTh ein abschaltbares Halbleiterbauelement der erfindungsgemessen Art ist, und
- die Ansteuereinrichtung einen Transistor enthält.

Der Kern der Erfindung besteht darin, einen normally-OFF-FCTh zu schaffen, indem mit geeigneten Dotierungen und angepasster Gate-Kathodengeometrie die Raumladungszonen im Langkanal jedes Kathodenfingers soweit zusammengezogen werden, dass bei Gate-Kathodenkurzschluss eine Injektion in das Kanalgebiet nicht möglich ist.

Gemäss einem bevorzugten Ausführungsbeispiel der Erfindung umfassen die Mittel Gatebereiche, welche sich als Wandschichten auch über die Grabenwände erstrecken und zusammen mit der n-leitenden Kanalschicht in den Kathodenfingern pn-Uebergänge bilden.

Wird ein solcher normally-OFF-FCTh als Steuerthyristor in einer Thyristorkaskade eingesetzt, entfällt die Notwendigkeit einer zweiten negativen Spannung.

Wird der normally-OFF-FCTh direkt als Hauptthyristor eingesetzt (ohne Kaskade), kann er sehr einfach mittels eines Feldeffekt- oder bipolaren Transistors angesteuert werden.

Weitere Ausführungsbeispiele der Erfindung ergeben sich aus den Unteransprüchen.

## KURZE BESCHREIBUNG DER ZEICHNUNG

Die Erfindung soll nachfolgend anhand von Ausführungsbeispielen im Zusammenhang mit der Zeichnung näher erläutert werden. Es zeigen:

Fig. 1 in Schnittansicht die Realisierung eines normally-ON-FCTh nach dem Stand der Technik;

Fig. 2 eine Schaltungsanordnung mit FCTh-Kaskade gemäss einer älteren Anmeldung;

Fig. 3 ausschnittsweise einen normally-ON-FCTh gemäss einer Ausführungsform der Erfindung;

Fig. 4A Thyristor-Kaskaden nach der Erfindung als Brückenzweige einer Umrichterschaltung;

Fig. 4B ein anderes Ausführungsbeispiel für einen Brückenzweig aus Fig. 4A;

Fig. 5A - C verschiedene Ausführungsbeispiele für eine Schaltungsanordnung mit einem erfindungsgemässen FCTh als Hauptthyristor und einem Transistor in der Ansteuereinrichtung.

## WEGE ZUR AUSFÜHRUNG DER ERFINDUNG

Der innere Aufbau eines normally-ON-FCTh nach dem Stand der Technik ist in einem perspektivischen Schnittbild in Fig. 1 dargestellt.

Der FCTh besitzt eine Anode A, eine Kathode K und ein Gate G, jeweils mit einem entsprechenden Anodenkontakt 11, Kathodenkontakt 1 und Gatekontakt 6 in Form von Metallisierungsschichten.

Zwischen Anode A und Kathode K ist eine Folge unterschiedlich dotierter Schichten angeordnet, die eine $p^+$-dotierte Anodenschicht 10, eine $n^-$-dotierte Kanalschicht 12, sowie kathodenseitig eine Mehrzahl von abwechselnd angeordneten $n^+$-dotierten Kathodenbereichen 13 und p-dotierten Gatebereichen 14 umfasst.

Die Kathodenbereiche 13 liegen auf der Oberseite von schmalen, z.B. 30 um breiten Kathodenfingern 4, die voneinander durch tiefe Gräben getrennt sind. Die Gatebereiche 14 erstrecken sich nicht nur über die Böden der Gräben, sondern auch als Wandschichten 14a über deren Seitenwände.

Die Wandschichten 14a schliessen in den Kathodenfingern 4 diejenigen Teile der Kanalschicht 12 ein, die bis zu den jeweiligen Kathodenbereichen 13 reichen.

Innerhalb der Kathodenfinger 4 bilden die p-dotierten Wandschichten 14a und die angrenzende $n^-$-dotierte Kanalschicht 12 pn-Uebergänge, deren Raumladungszonen 5 in die Kanalschicht 12 hineinreichen und einen feldeffektsteuerbaren Langkanal innerhalb der Kathodenfinger 4 aufbauen. (Es sei an dieser Stelle darauf verwiesen, dass ein feldeffektsteuerbarer Langkanal nicht nur mit den in die Grabenwände hochgezogenen Gatebereichen realisiert werden kann, sondern auch mit isolierten Feldplatten oder npn-Transistorstrukturen, wie dies Gegenstand der älteren Europäischen Patentanmeldung Nr. 87107918.2 ist.)

Nach Bedarf kann zwischen der Anodenschicht 10 und der Kanalschicht 12 eine n-dotierte Stoppschicht 9 vorgesehen werden, wie sie in Fig. 1 eingezeichnet ist.

Die Gatebereiche 14 stehen auf den Grabenböden mit dem Gatekontakt 6 in Verbindung. Auf der Oberseite der Kathodenfinger 4 sind die Wandschichten 14a mittels $SiO_2$-Schichten 3 isolierend abgedeckt, während die Kathodenbereiche 13 mit einer Kathodenmetallisierung 2 in Kontakt stehen. Die Kathodenmetallisierung 2 ihrerseits ist mit dem Kathodenkontakt 1 verbunden.

Zu Schutz- und Isolierzwecken ist weiterhin eine Polyimidpassierung 7 vorgesehen. Als Randabschluss dient ein Randgraben 8, welcher die Durchbruchspannung erhöht.

Es sei an dieser Stelle darauf hingewiesen, dass die Kathodenfinger 4, wie im Beispiel der Fig. 1 dargestellt, nicht notwendig über eine tieferliegende Gateebene herausragen müssen. Ebensogut ist auch eine Realisierung des Bauelements denkbar, bei dem lediglich die zwischen den Kathodenfingern liegenden Gräben in das Substrat hineingeätzt werden, das Bauelement im übrigen auf der Kathodenseite jedoch planar ausgeführt ist (siehe dazu die EP-0 243 684).

Die Dimensionierung eines normally-ON-FCTh gemäss Fig. 1 (Geometrie und Dotierungskonzentrationen), insbesondere im Bereich der Gate-Kathodenstruktur, kann z.B. der EP-A2 0 178 387 entnommen werden. Charakteristische Werte sind:

| Breite der Kathodenfinger 4: | 30 μm |
|---|---|
| Tiefe der Wandschicht 14a: | 5 μm |
| Grunddotierung der Kanalschicht 12: | $2 \cdot 10^{13}$ cm$^{-3}$ |
| Wandschichtdotierung: | $10^{16}$ cm$^{-3}$ |

Bei diesen Ausgangsparametern reichen die (in Fig. 1 strichliert eingezeichneten) Raumladungszonen 5 nicht weit genug in die Kanalschicht der Kathodenfinger 4 hinein, um den Langkanal vollständig auszuräumen und damit die Ladungsträgerinjektion zu verhindern, wenn Gate G und Kathode K kurzgeschlossen sind: Das Bauelement hat daher die beschriebene normally-ON-Eigenschaft.

Genau diese Eigenschaft führt nun zu einer FCTh-Kaskadenschaltung gemäss Fig. 2, wie sie in der eingangs genannten älteren Anmeldung beschrieben ist.

In dieser Schaltung bilden ein erster normally-ON-FCTh Th1 als Hauptthyristor und ein zweiter normally-On-FCTh Th2 als Steuerthyristor eine Kaskade.

Der Hauptthyristor Th1 ist in Reihe mit einem Lastwiderstand $R_L$ zwischen den positiven Pol einer Lastspannung $U_L$ und die Schaltungsmasse geschaltet, wobei seine Kathode K1 an Schaltungsmasse liegt, und seine Anode A1 entsprechend mit der positiven Spannung beaufschlagt ist.

Das Gate G1 des Hauptthyristors Th1 ist einerseits über einen Widerstand $R_4$ mit der Schaltungsmasse verbunden, andererseits direkt an die Anode A2 des Steuerthyristors Th2 angeschlossen.

Die Kathode K2 des Steuerthyristors Th2 liegt über einen Vorwiderstand R3 an einer ersten negativen Versorgungsspannung $U_1$. Weiterhin ist sie durch einen Kondensator C2 wechselspannungsmässig mit der Schaltungsmasse verbunden und über einen Widerstand R2 an das Gate G2 des Steuerthyristors Th2 angeschlossen.

Eingangsseitig ist als Ansteuereinrichtung ein Optokoppler 15 vorgesehen, der im Eingang eine LED 16 und im Ausgang einen Phototransistor 17 aufweist.

Das Gate G2 des Steuerthyristors Th2 führt auf den Kollektor des Phototransistors, während dessen Emitter über einen weiteren Vorwiderstand R1 mit einer zweiten negativen Versorgungsspannung $U_2$ beaufschlagt wird und zugleich über einen Kondensator C1 an Schaltungsmasse liegt.

Die Werte dieser Schaltung sind z.B. folgende:

| R1: | 1 kOhm |
|---|---|
| R2: | 10 kOhm |
| R3: | 100 Ohm |
| R4: | 4,7 kOhm |
| C1: | 10 $\mu$F |
| C2: | 100 $\mu$F |
| $U_1$: | -60 V |
| $U_2$: | -80 V |

Die Funktion der Schaltung kann so erläutert werden: Der Hauptthyristor Th1 ist immer dann eingeschaltet, wenn der Steuerthyristor Th2 abgeschaltet ist und umgekehrt.

Solange kein Eingangssignal auf die LED 16 gelangt, ist der Phototransistor 17 des Optokopplers 15 gesperrt. Kathode K2 und Gate G2 des Steuerthyristors Th2 liegen dann etwa auf demselben Potential, so dass Th2 als normally-ON-Bauelement durchgeschaltet ist.

Weil der Steuerthyristor Th2 durchgeschaltet ist, liegt am Gate G1 des Hauptthyristors Th1 die volle Versorgungsspannung $U_1$ von -60 V, d.h. Th1 ist gesperrt.

Wenn nun der Phototransistor 17 durch die LED 16 eingeschaltet wird, wird zunächst mit einem kurzen Stromstoss über das Gate G2 die Sperrschichtladung im Gate-Kathodenbereich des Steuerthyristors Th2 ausgeräumt. Zwischen dem Gate G2 und der Kathode K2 des Steuerthyristors Th2 liegt dann eine Spannung von -20 V. Der Steuerthyristor Th2 sperrt. Die entsprechende Sperrschichtkapazität in der Gate-Kathodenstrecke des Hauptthyristors Th1 entlädt sich über den Widerstand R4 und in Form eines Gatestroms, der beim Einschalten von Th1 fliesst.

Im stationären Zustand leitet der Hauptthyristor Th1 schliesslich den Laststrom und weist zwischen seinem Gate G1 und seiner Kathode K1 eine positive Spannung von etwa 1 V auf, die aus dem Strom durch die Anode A1 resultiert. Th2 bleibt gesperrt.

Beim Ausschalten des Phototransistors 17 wird nach einem wiederum kurzzeitigen Uebergang wieder der andere stationäre Zustand erreicht, in welchem der Hauptthyristor Th1 gesperrt und der Steuerthyristor Th2 durchgeschaltet ist.

Aus der obigen Erklärung des Betriebsverhaltens geht unmittelbar hervor, dass die beiden unterschiedlichen negativen Versorgungsspannungen $U_1$ und $U_2$ notwendig sind, um einen sicheren Betrieb einer Kaskade mit zwei normally-ON-FCThs zu gewährleisten.

Die Bereitstellung von zwei Versorgungsspannungen $U_1$ und $U_2$ bedeutet einen erhöhten schaltungstechnischen Aufwand auf der Versorgungsseite. Dieser Aufwand lässt sich vermeiden, wenn als Steuerthyristor Th2 ein FCTh mit normally-OFF-Eigenschaften eingesetzt wird, wie er sich aus der vorliegenden Erfindung ergibt.

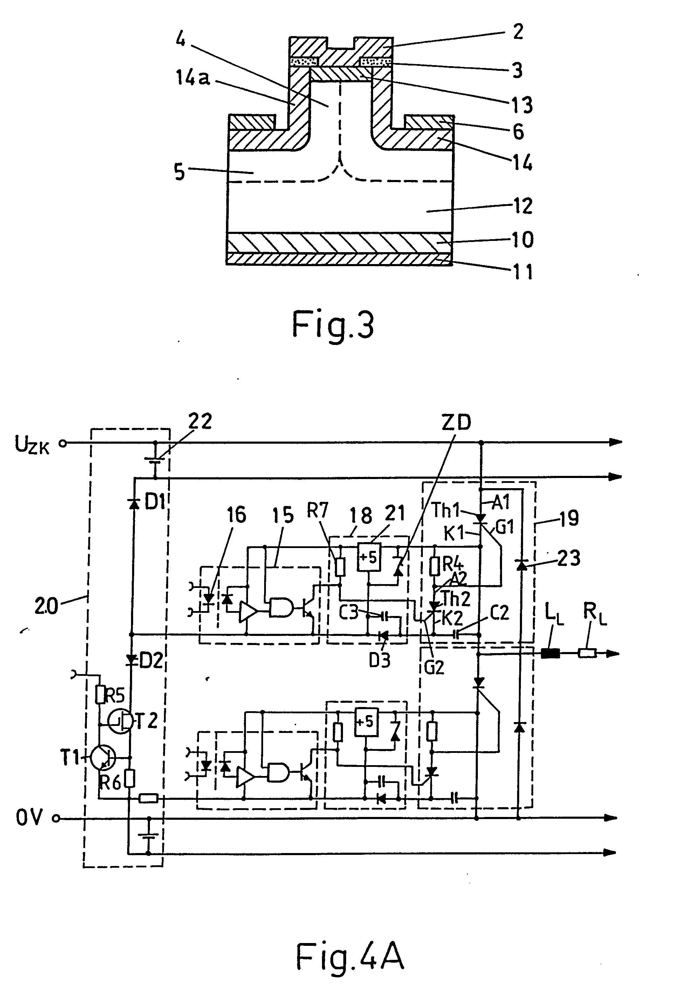

Der erfindungsgemässe FCTh kann anhand der Fig. 3 erläutert werden, die einen Teil des Thyristors mit einem der vielen Kathodenfinger 4 im Schnitt darstellt.

Der strukturelle Aufbau des FCTh aus Fig. 3 ist im wesentlichen dergleiche, wie beim bekannten FCTh aus Fig. 1 (die Stoppschicht 9 ist in Fig. 3 allerdings der Einfachheit halber gar nicht eingezeichnet).

Der entscheidende Unterschied liegt in der Dimensionierung der einzelnen Schichten, insbesondere im Gate-Kathodenbereich: Während beim bekannten FCTh aus Fig. 1 die Raumladungszonen 5 das Kanalgebiet in den Kathodenfingern 4 lediglich einengen (bei gleichem Potential von Gate und Kathode) und erst dann abschnüren, wenn das Gate gegenüber der Kathode hinreichend negativ vorgespannt ist, ist der erfindungsgemässe FCTh im Bereich der Kathodenfinger 4 so dimensioniert, dass bereits beim Kurzschluss zwischen Gate und Kathode die Raumladungszonen 5 soweit in die Kanalschicht der Kathodenfinger hineinreichen, dass der Langkanal gesperrt ist.

Im einfachen Fall der Fig. 3 geschieht dies in der Weise, dass sich die in einem Kathodenfinger gegenüberliegenden Raumladungszonen in der Mitte des Kathodenfingers zumindest berühren, so dass die Kanalschicht im Bereich des Kathodenfingers vollständig von Elektronen freigeräumt ist. Mit dem Fehlen der Elektronen wird aber zugleich auch die Löcherinjektion aus der Anodenschicht 10 unterbunden: Das Bauelement ist, solange Gate und Kathode kurzgeschlossen sind, gesperrt.

Die in Fig. 3 dargestellte Konfiguration der Raumladungszonen lässt sich auf verschiedenen Wegen erreichen:

- bei gleichbleibender Dotierung aller Schichten und gleichbleibender Dicke der Wandschichten 14a kann die Breite der Kathodenfinger 4 (und damit die Breite des Kanalgebiets im Kathodenfinger 4) soweit verringert werden, bis die Raumladungszonen 5 einander berühren oder durchdringen;
- bei gleichbleibender Geometrie kann die Dotierungskonzentration in der Kanalschicht 12 soweit verringert werden, bis die Raumladungszonen 5 hinreichend tief geworden sind, um sich zu berühren;
- bei gleichbleibender Dotierung aller Schichten und gleichbleibender Dicke der Kathodenfinger 4 können die Wandschichten 14a entsprechend tiefer in die Kathodenfinger hineindiffundiert werden; oder
- zwei oder alle diese Parameter werden entsprechend gleichzeitig verändert.

BEISPIEL:

Ausgehend von den vorher genannten charakteristischen Werten für einen normally-ON-FCTh gemäss Fig. 1 lässt sich ein normally-OFF-FCTh schaffen, wenn die Grunddotierung der Kanalschicht 12 von 2 $\cdot$ $10^{13}$ cm$^{-3}$ auf 1 $\cdot$ $10^{13}$ cm$^{-3}$ reduziert wird.

Für die anderen Fälle, in denen die Mittel in den Grabenwänden nicht die Wandschichten 14a der Gatebereiche 14 umfassen, sondern isolierte Feldplatten oder Transistorstrukturen, können entsprechende Massnahmen ergriffen werden, um die Raumladungszonen in geeigneter Weise zu gestalten.

Welche Vorteile der erfindungsgemässe normally-OFF-FCTh in der schaltungstechnischen Anwendung bringt, soll anhand der Fig. 4A näher erläutert werden. Fig. 4A zeigt den Brückenzweig eines Umrichters mit zwei weitgehend identischen Halbbrücken, von denen der Einfachheit halber nur die obere Halbbrücke 19 und deren Ansteuereinrichtung mit Bezugszeichen versehen und zur Erklärung herangezogen wird.

Die Halbbrücke 19 enthält die bereits aus Fig. 2 bekannte Kaskadenschaltung aus einem Hauptthyristor Th1 (z.B. einem normally-ON-FCTh) und einem Steuerthyristor Th2, welche miteinander in an sich bekannter Weise über den Widerstand R4 und den Kondensator C2 verschaltet sind. Der Kondensator C2 speichert dabei die Ladung, die für den kurzzeitigen Abschaltstrom am Gate G1 des Hauptthyristors Th1 benötigt wird.

Der Steuerthyristor Th2 ist nun ein erfindungsgemässer normally-OFF-FCTh, der auch sperrt, wenn sein Gate G2 und seine Kathode K2 auf demselben Potential liegen.

Am Eingang der Halbbrücke liegt wiederum ein Optokoppler 15 mit einer eingangsseitigen LED 16. Der Optokoppler 15 kann z.B., wie in Fig. 4A dargestellt, vom Typ MCL 2601 sein und enthält dann eine ausgangsseitige Logik, die eine Versorgungsspannung von etwa +5 V benötigt.

Die Versorgung des Optokopplers 15 und des Steuerthyristors Th2 wird mittels eines Hilfsteils 18 aus nur noch einer einzigen Spannungsquelle 22 sichergestellt, die in einem Versorgungsteil 20 angeordnet ist.

Der Hilfsteil 18 enthält einen (+5 V)-Spannungskonstanter 21, einen Widerstand R7, eine Zenerdiode ZD, sowie die Parallelschaltung aus einer Diode D3 und einem Kondensator C3, welche sicherstellen, dass die notwendigen Spannungspegel eingehalten werden.

Der Versorgungsteil 20 enthält zwei Dioden D1, D2 sowie eine aus den Transistoren T1, T2 und den Widerständen R5 und R6 gebildete Konstantstromquelle.

Die ganze Brücke liegt eingangsseitig an einer Zwischenkreisspannung $U_{ZK}$ und arbeitet ausgangsseitig auf eine Last mit einer Lastinduktivität $L_L$ und einem Lastwiderstand $R_L$. Die in Fig. 4A nicht eingezeichneten Brückenzweige schliessen sich in entsprechender Weise an diejenigen Verbindungsleitungen an, die auf der rechten Seite der Figur mit einem Pfeil versehen sind.

Die Ansteuerung der Halbbrücke 19 über den Optokoppler 15 kann in herkömmlicher Weise mittels einer Ansteuerlogik erfolgen, wie sie auch in herkömmlichen Umrichterschaltungen Verwendung findet.

Wesentlich ist bei der Schaltung nach Fig. 4A die Versorgung der floatenden oberen Halbbrücke 19: Während des normalen Umrichterbetriebs wird der Kondensator C2 aus der oberen Span nungsquelle 22 nachgeladen. Die oben erwähnte Konstantstromquelle im Versorgungsteil ist dann ausgeschaltet.

Bei einem äusseren Kurzschluss und auch beim Anfahren des Umrichters wird dagegen die Konstantstromquelle eingeschaltet. Auf diese Weise ist die Versorgung der Optokoppler-Logik und des Kondensators C2 auch in diesen kritischen Fällen gewährleistet.

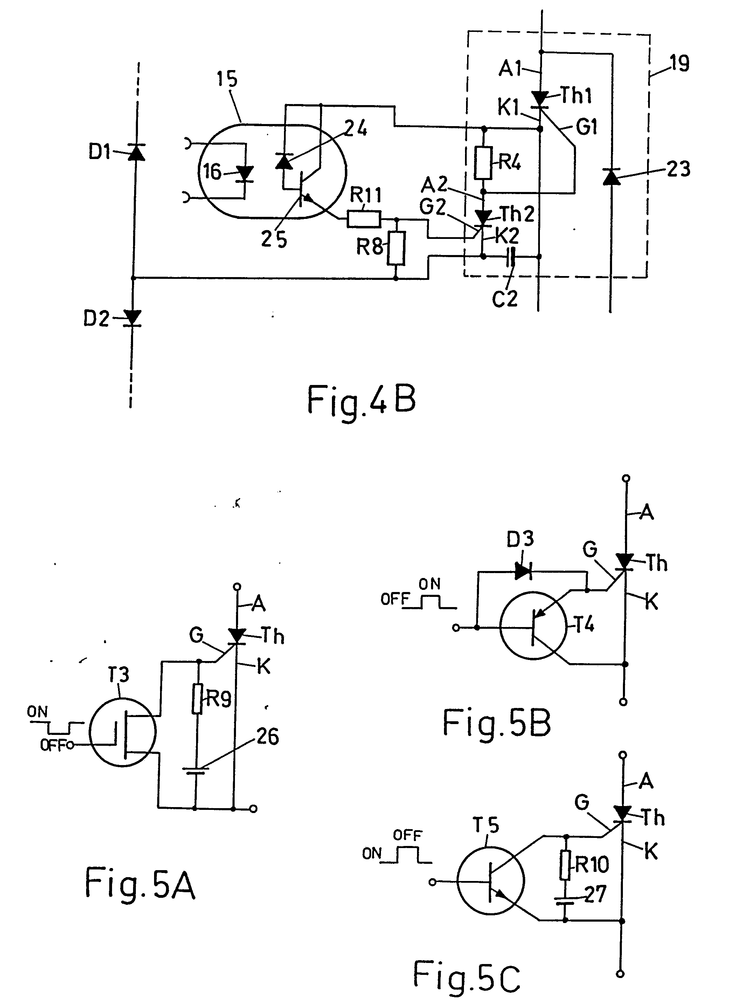

Eine alternative Ansteuerung der Halbbrücke ist in Fig. 4B dargestellt. Hier wird ein Optokoppler 15 eingesetzt, der ausgangsseitig eine Photodiode 24 mit nachfolgender Transistorstufe 25 aufweist.

Der Optokoppler schaltet das Gate G2 des Steuerthyristors Th2 auf positives Potential, während ein Widerstand R8 es bei ausgeschalteter Transistorstufe 25 auf das Potential der Kathode K2 zieht. Der Widerstand R11 dient der Strombegrenzung. Eine solche Konfiguration ist vor allem dann angebracht, wenn Optokoppler zur Verfügung stehen, welche die in der Halbbrücke auftretenden Spannungssteilheiten von bis zu 15 kV/$\mu$s erreichen können.

Der entscheidende Vorteil beider Schaltungen (Fig. 4A und B) liegt darin, dass bei Einsatz eines erfindungsgemässen normally-OFF-FCTh als Steuerthyristor Th2 nur noch eine Versorgungsspannung notwendig ist, um die notwendigen Schaltzustände der Kaskade sicher herbeizuführen.

6

Der erfindungsgemässe FCTh bietet jedoch auch wesentliche Vorteile, wenn er nicht als Steuerthyristor in einer Thyristorkaskade, sondern direkt als Hauptthyristor eingesetzt wird. Solch ein normally-OFF-FCTh kann z.B. den GTO ersetzen, weil er genauso angesteuert werden und dabei die gleichen Funktionen übernehmen kann. Schaltungen mit dem FCTh können dann mit der gleichen Störfall-Logik betrieben werden, die bereits für GTO-Schaltungen entwickelt wurde - die Betriebs daten aber würden den Vorzügen des FCTh entsprechend verbessert.

Weiterhin kann ein solcher FCTh auch ohne negative Versorgungsspannung $U_1$, betrieben werden: Dem FCTh ist hierbei eine Ansteuereinrichtung zugeordnet, die einen Transistor enthält.

Drei Ausführungsbeispiele einer solchen einfachen Transistor-FCTh-Kombination sind in den Fig. 5A-C wiedergegeben.

Im Beispiel der Fig. 5A ist ein normally-OFF-FCTh Th mit einem Feldeffekttransistor T3 kombiniert, der mit seiner Drain-Source-Strecke parallel zur Gate-Kathoden-Strecke des FCTh und zu einer Serienanordnung aus einer Spannungsquelle 26 und einem Widerstand R9 geschaltet ist.

Wenn der Feldeffekttransistor T3 durchgeschaltet ist, liegt das Gate G des FCTh Th auf dem Potential der Kathode K: der FCTh ist im OFF-Zustand.

Sperrt dagegen der Feldeffekttransistor T3, wird das Gate G durch die Spannungsquelle 26 gegenüber der Kathode K positiv vorgespannt: Der FCTh ist im ON-Zustand.

Da zum Einschalten des FCTh das Gate nur positive Ladung erhalten muss, kann selbstverständlich die Spannungsquelle 26 auch durch eine Einrichtung ersetzt werden, die nur diesen notwendigen positiven Puls beim Einschalten liefert, z.B. einen Impulstransformator mit der entsprechenden Ansteuerung. Auch ein zum Ansteuersignal invertierter Puls kann zu diesem Zweck herangezogen werden.

Im Beispiel der Fig. 5C ist eine zu Fig. 5A vergleichbare Schaltung dargestellt, die anstelle des Feldeffekttransistors einen bipolaren npn-Transistor T5 aufweist, zu dessen Kollektor-Emitter-Strecke die Serienanordnung aus Spannungsquelle 27 und Widerstand R10 parallelgeschaltet ist.

Im Beispiel der Fig. 5B liegt der Gate-Kathoden-Strecke des FCTh die Emitter-Kollektor-Strecke eines bipolaren pnp-Transistors T4 parallel. Zusätzlich ist zwischen Basis und Emitter des pnp-Transistors T4 eine in Durchlassrichtung gepolte Diode D3 angeordnet. Hier schaltet der FCTh nur in den ON-Zustand, wenn auf die Basis von T3 ein positiver Impuls gelangt.

Für alle drei Schaltungsbeispiele sind in den Figuren zur Verdeutlichung die entsprechenden Ansteuerimpulse angedeutet.

Da der FCTh als Bauelement mit bipolaren und Feldeffekt-Eigenschaften ausgestattet ist, lässt sich die Ansteuereinrichtung mit den bipolaren bzw. Feldeffekttransistoren besonders vorteilhaft mit dem FCTh zu einer baulichen Einheit zusammenfassen, bei der FCTh und Transistor auf einen gemeinsamen Substrat integriert sind.

Insgesamt stehen mit der Erfindung ein neues Bauelement und neue Schaltungsanordnungen zur Verfügung, die einerseits die Vorteile des FCTh (bipolare Ladungsträgerinjektion und leistungsarme Feldsteuerung) und andererseits einen besonders einfachen Schaltungsaufbau ermöglichen.

## Ansprüche

1. Abschaltbares Halbleiterbauelement in Form eines feldgesteuerten Thyristors (FCTh) mit einer Anode (A), einer Kathode (K) und einem Gate (G), umfassend zwischen der Anode (A) und der Kathode (K)

(a) eine p-leitende Anodenschicht (10),

(b) eine darüberliegende, n-leitende Kanalschicht (12), und

(c) eine Mehrzahl von auf der Kathodenseite abwechselnd angeordneten n-leitenden Kathodenbereichen (13) und p-leitenden Gatebereichen (14), wobei

(d) die Kathodenbereiche (13) auf durch Gräben voneinander getrennten Kathodenfingern (4) angeordnet sind,

(e) die Gatebereiche (14) sich über die Böden der Gräben erstrecken, und

(f) in den Grabenwänden Mittel vorgesehen sind, welche Raumladungszonen (5) erzeugen, die innerhalb der Kathodenfinger (4) in die Kanalschicht (12) hineinreichen und in jedem Kathodenfinger (4) einen feldeffektsteuerbaren Langkanal bilden,
dadurch gekennzeichnet, dass

(g) in den Kathodenfingern (4) die Raumladungszonen (5) bei einem Kurzschluss zwischen Gate (G) und Kathode (K) soweit in die in den Kathodenfingern (4) befindliche Kanalschicht hineinreichen, dass der Langkanal gesperrt ist.

2. Abschaltbares Halbleiterbauelement nach Anspruch 1, dadurch gekennzeichnet, dass sich die Raumladungszonen (5), welche sich innerhalb eines Kathodenfingers (4) gegenüberliegen, bei einem Kurzschluss zwischen Gate (G) und Kathode (K) innerhalb des gesamten Langkanals gegenseitig zumindestens berühren.

3. Abschaltbares Halbleiterbauelement nach Anspruch 1, dadurch gekennzeichnet, dass die Mittel Gatebereiche (14) umfassen, welche sich als Wandschichten (14a) auch über die Grabenwände erstrecken, und zusammen mit der n-leitenden Kanalschicht (12) in den Kathodenfingern (4) pn-Uebergänge bilden.

4. Schaltungsanordnung mit einer Thyristorkaskade, welche Thyristorkaskade einen ersten FCTh (Th1) als Hauptthyristor und einen zweiten FCTh (Th2) als Steuerthyristor umfasst, dadurch gekennzeichnet, dass der zweite FCTh (Th2) ein abschaltbares Halbleiterbauelement gemäss Anspruch 1 ist.

5. Schaltungsanordnung nach Anspruch 4, dadurch gekennzeichnet, dass

(a) der zweite FCTh (Th2) mit seiner Anode (A2) am Gate (G1) des ersten FCTh (Th1) angeschlossen ist,

(b) die Kathode (K2) des zweiten FCTh (Th2) über einen Kondensator (C2) mit der Kathode (K1) des ersten FCTh (Th1) verbunden ist,

(c) das Gate (G1) des ersten FCTh (Th1) über einen Widerstand (R4) mit der Kathode (K1) des ersten FCTh (Th1) verbunden ist,

(d) das Gate (G2) des zweiten FCTh (Th2) mit einer Ansteuereinrichtung in Verbindung steht, und

(e) die Ansteuereinrichtung und der zweite FCTh (Th2) aus einer gemeinsamen Spannungsquelle (22) versorgt werden.

6. Schaltungsanordnung nach Anspruch 5, dadurch gekennzeichnet, dass

(a) die Ansteuereinrichtung einen Optokoppler (15) enthält, und

(b) die Thyristorkaskade einen Brückenzweig in einer Umrichter-Brückenschaltung bildet.

7. Schaltungsanordnung mit einem FCTh (Th) und einer Ansteuereinrichtung, dadurch gekennzeichnet, dass

(a) der FCTh (Th) ein abschaltbares Halbleiterbauelement gemäss Anspruch 1 ist, und

(b) die Ansteuereinrichtung einen Transistor (T3, T4, T5) enthält.

8. Schaltungsanordnung nach Anspruch 7, dadurch gekennzeichnet, dass

(a) der Transistor ein Feldeffekttransistor (T3) ist,

(b) der Feldeffekttransistor (T3) mit Source und Drain zwischen Kathode (K) und Gate (G) des FCTh (Th) angeordnet ist, und

(c) zwischen Kathode (K) und Gate (G) des FCTh (Th) die Serienschaltung aus einer Spannungsquelle (26) und einen Widerstand (R10) angeordnet ist.

9. Schaltungsanordnung nach Anspruch 7, dadurch gekennzeichnet, dass

(a) der Transistor ein bipolarer pnp-Transistor (T4) ist,

(b) der Emitter des Transistors mit dem Gate (G) des FCTh (Th) und der Kollektor des Transistors mit der Kathode (K) des FCTh (Th) verbunden sind, und

(c) zwischen Basis und Emitter des Transistors eine in Durchlassrichtung gepolte Diode (D3) angeordnet ist.

10. Schaltungsanordnung nach Anspruch 7, dadurch gekennzeichnet, dass

(a) der Transistor ein bipolarer npn-Transistor (T5) ist,

(b) der Kollektor des Transistors mit dem Gate (G) des FCTh (Th) und der Emitter des Transistors mit der Kathode (K) des FCTh (Th) verbunden sind, und

(c) zwischen Gate (G) und Kathode (K) des FCTh (Th) die Serienschaltung aus einer Spannungsquelle (27) und einem Widerstand (R11) angeordnet ist.

11. Schaltungsanordnung nach Anspruch 6, dadurch gekennzeichnet, dass der FCTh und der Transistor (T3, T4, T5) der Ansteuereinrichtung auf einem gemeinsamen Substrat integriert sind.

Fig.1

Fig.2

Fig.3

Fig.4A

Fig.4B

Fig.5A

Fig.5B

Fig.5C

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,Y | EP-A-0 178 387 (BBC AG)<br>* Seite 5, Zeile 7 - Seite 7, Zeile 19; Figur 1 *<br>--- | 1-3 | H 01 L 29/72<br>H 03 K 17/73<br>H 03 K 17/78 |
| Y | EP-A-0 029 932 (GENERAL ELECTRIC CO.)<br>* Zusammenfassung; Figur 2A *<br>--- | 1-3 | |
| A | INTERNATIONAL ELECTRON DEVICES MEETING TECHNICAL DIGEST, San Francisco, 13.-15. Dezember 1982, Seiten 480-483, IEEE, New York, US; Y. NAKAMURA et al.: "Normally-off type high speed SI-thyristor"<br>* Insgesamt *<br>--- | 1-3 | |
| A | IBM TECHNICAL DISCLOSURE BULLETIN, Band 13, Nr. 2, Juli 1970, Seiten 341-342, New York, US; B.M. GRIFFING et al.: "Power pulse firing circuit"<br>* Insgesamt *<br>--- | 4,5 | |
| A | DE-A-3 425 414 (SIEMENS AG)<br>* Zusammenfassung; Figur 1 *<br>--- | 7,8 | RECHERCHIERTE SACHGEBIETE (Int. Cl.4)<br><br>H 01 L<br>H 03 K |
| A | US-A-3 821 565 (HORINAGA)<br>* Zusammenfassung; Figur 1 *<br>--- | 4 | |
| A | US-A-4 456 836 (MATSUDA et al.)<br>* Zusammenfassung; Figur 1a *<br>----- | 7,9,10 | |

Der vorliegende Recherchenbericht wurde für alle Patentansprüche erstellt

| Recherchenort | Abschlußdatum der Recherche | Prüfer |
|---|---|---|
| DEN HAAG | 14-12-1988 | BAILLET B.J.R. |